# EUROPEAN PATENT SPECIFICATION

(11) **EP 0 534 769 B1**
(45) Date of publication and mention of the grant of the patent: **23.07.1997**
(21) Application number: 92308738.1
(22) Date of filing: 25.09.1992
(51) Int. Cl.: H04N 5/217, H04N 3/15, H04N 5/33

(54) **Readout system and process for IR detector arrays**
Lese-System und Verfahren für Infrarotdetektoranordnungen
Système et procédé de lecture pour des réseaux de détecteurs infrarouges

(30) Priority: 27.09.1991 US 766879; 30.09.1991 US 768801
(43) Date of publication of application: 31.03.1993
(73) Proprietor: TEXAS INSTRUMENTS INCORPORATED, Dallas Texas 75265 (US)
(72) Inventor: Keenan, William F., Plano, Texas 75075 (US)
(74) Representative: Blanco White, Henry Nicholas

(56) References cited:
- EP-A- 0 019 269
- EP-A- 0 230 809
- EP-A- 0 354 369
- WO-A-90/03080
- US-A- 4 752 741

## Description

### FIELD OF THE INVENTION

This invention generally relates to the fabrication of semiconductor devices and specifically to a readout system and process for infrared detector arrays.

### BACKGROUND OF THE INVENTION

Detection of infrared radiation emitted by warm bodies provides an important method for night vision (perception without visible light). Infrared detectors may be classified in various ways, such as scanning or staring arrays, cryogenic (typically liquid nitrogen temperatures) or uncooled detectors, 3-5 micron or 8-12 micron spectral sensitivity range, and photon or thermal detection mechanism. For portable, low power applications where the greater detectivity of cryogenic detectors is not needed, the preferred choice is an uncooled thermal detector: infrared photons are absorbed and the resultant heating of the absorbing element is detected. The thermal detector is usually one of three types: (1) pyroelectric detector, (2) thermocouple, or (3) bolometer.

In the operation of an infrared (IR) image sensing array, the desired output signal is obtained from the difference between two consecutive array outputs. The first output is obtained with the IR image deliberately defocused on the array and is used to determine the background flux associated with the scene. The second output is obtained with the image sharply focused on the array.

Typically, the signal from either the dark frame or from both frames are digitized and stored in memory for subsequent signal processing operation. This analogue to digital conversion and storage memory add to the cost and complexity of the overall imaging system.

Accordingly, improvements which overcome any or all of the problems are presently desirable.

EP-A-0 019 269 (on which the preambles of claims 1 and 10 are based) discloses a pixel detector and method for detecting the intensity of radiation emanating from an object using a radiation dependent resistor. Radiation emanating from the object is selectively blocked from the resistor by a shutter. Two capacitors are charged to a reference voltage of -15 V. With the shutter open, a first switch is closed between the first capacitor and the resistor allowing the first capacitor to discharge for a given length of time at a rate indicative of the incident radiation intensity. With the shutter closed, a second switch is closed between the second capacitor and the resistor, allowing the second capacitor to discharge at a rate indicative of the intensity of "thermal background radiation". Then, with the first and second switches open a third switch enables an output device which combines the remaining charge on the two capaciors. Circuitry to construct an output signal for each pixel using this method requires two capacitors and six control signals, each signal requiring a switching transistor.

EP-A-0 230 809 discloses a thermal parallel scan camera using columns of photodiodes, in which the dynamic range of the signals is reduced by a feedback loop that varies the length of time for which the current from each photodiode is integrated to produce a detection charge signal. The consequent reduction in the signal gain causes a reduction in the signal-to-noise ratio. In order to reduce that problem, the charge signal is converted into a voltage signal, summed over a line of photodiodes. During the scanning return period the photodiodes are exposed to a uniform reference background at a predetermined temperature and the voltage signal is fed to a capacitor, the other terminal which is connected to a reference voltage source. The capacitors associated with the different rows of photodiodes thus acquire charges indicative of the "steady spatial noise" caused by variations between the detectors for different lines. During the scanning period, a train of voltage signals are fed to the capacitor, the other terminal of which is allowed to float, and its voltage is converted to a charge signal in which the steady spatial noise component is supposed to be reduced as compared with the first-mentioned charge signal.

The invention provides a pixel detector for detecting radiation emanating from an object and focused onto the detector, wherein the said focused radiation alternates with reference radiation, the said pixel detector comprising: a resistive detector element with a resistance dependent on the said radiation and having first and second terminals; a capacitor; circuitry for applying a reference voltage; and circuitry for sensing an ouput voltage dependent upon a difference between said focused radiation and said reference radiation; characterised in that the said capacitor and the said circuitry for applying a reference voltage are coupled to the first terminal of the resistive detector element; in that the pixel detector comprises bias circuitry for applying to the second terminal of said resistive detector element a first voltage when said reference radiation is incident on the detector element and a second voltage when the focused radiation is incident on the detector element, the reference voltage being between the first and second voltages; in that the detector is for use with defocused background radiation as the said reference radiation; and in that the output voltage is a voltage on the first terminal of the resistive element.

The invention also provides a method of detecting the intensity of radiation emanating from an object relative to a reference radiation intensity at a pixel detector, comprising the steps of: providing a resistive element with a resistance dependent upon the intensity of radiation impinging on said detector and having first and second terminals; providing an integration element coupled to the first terminal of the resistive element; setting said first terminal to a reference voltage; exposing said detector to said reference radiation and applying a first voltage to the second terminal of said resistive element and integrating corresponding to the reference radiation level; focusing said radiation on said detector; and sensing an output voltage level; characterised by: exposing the said detector to defocused radiation from the object as the said reference radiation; setting the second terminal of the resistive element to a second voltage while focusing said radiation on said detector and integrating corresponding to the focused radiation level, the reference voltage being between the first and second voltages; and sensing a voltage level in the integrating element as the said output voltage level.

An advantage of the invention is that it reduces dynamic range requirements on the preamplifier. This simplifies the overall system design. In addition, external "dark" frame storage (i.e., background) requirements are eliminated. This reduces the amount of memory necessary.

Further, the effects of radiation independent currents on pixel performance are minimized since these currents will be calibrated out. Still further, the effects of drift in the mean pixel temperature on detector performance are minimized.

Even further still, the present invention allows the electrical integration time to be substantially less than the frame time which is an advantage in the capacitance/resistor current performance tradeoff.

The above features of the present invention will be more clearly understood from consideration of the following descriptions in connection with accompanying drawings in which:
Figure 1 shows a block diagram of an infrared detector system which includes a first preferred embodiment bolometer array;
Figure 2 shows a schematic diagram of a pixel detector;
Figure 3 shows an exemplary output voltage;
Figure 4 illustrates a first embodiment timing diagram; and
Figure 5 illustrates a second embodiment timing diagram.

Corresponding numerals and symbols in the different figures refer to corresponding parts unless otherwise indicated.

The making and use of the presently preferred embodiments are discussed below in detail.

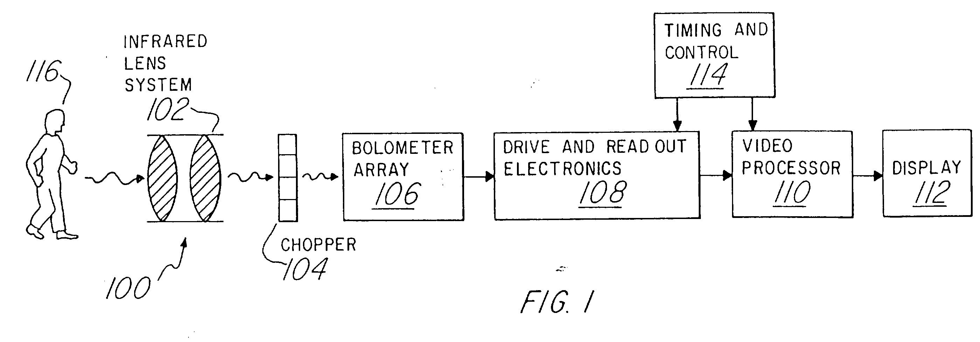

Figure 1 illustrates in schematic diagram view an infrared imagery system, generally noted 100, which includes infrared lens system 102 which may include a shutter for focusing and defocusing the infrared image, mechanical chopper 104, bolometer array 106, drive and readout electronics 108 for array 106, video processor 110, display 112, and timing and control electronics 114. The lens system 102 images infrared radiation emitted by warm object 116 onto array 106. Chopper 104 may be a rotating disk which periodically defocuses the infrared radiation collected by lens system 102. In one embodiment, array 106 includes 65,536 bolometers arranged in 256 rows by 256 columns; each bolometer corresponds to a pixel in the image of the warm body 116 plus surrounding scene in the field of view of the lens system 102. Array 106 may be housed in a vacuum chamber or be surrounded by a low thermal conductivity atmosphere. An infrared transparent window is formed in one side of the device package. The window is positioned so that radiation from the scene with warm body 116 passes through the window onto array 106.

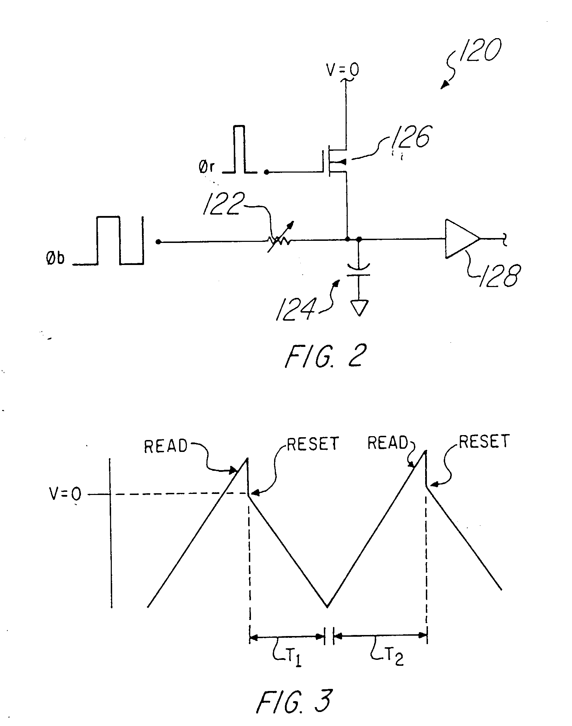

The following description relates primarily to the bolometer array 106 and the drive and read out electronics 108 as well as the focusing/defocusing shutter which is included in lens system 102 and/or chopper 104. Figure 2 shows one pixel detector 120 in the array 106. The pixel detector 120 comprises a temperature dependent resistor 122. During operation, the temperature of resistor 122 will be proportional to the intensity of the radiation impinging upon the pixel. Any of the many known pixel configurations may be used. Examples of uncooled bolometer pixel configurations are given in U.S. Patent US-A-5,021,663; and in U.S. Patent Application Serial No. 768,801, from which the present application claims priority, and corresponding EP-A 0 534 768 (TI-16334EU) of even date with the present application.

The resistor 122 is coupled to a bias voltage Φ_{b} at one terminal and an integration capacitor 124 at the other terminal. Many methods of fabricating capacitors in integrated circuits are known and any of these capacitors may be used. A reset switch 126 is also coupled to the node with resistor 122 and capacitor 124. As an example, the reset switch 126 may be a field effect transistor as illustrated in Figure 2. Preamplifier 128 is coupled to the same node to sense the value of the voltage on capacitor 124. Known signal multiplexing may be used after the preamplifier output, but this is not critical to the invention herein.

In operation, the temperature dependent resistor 122 charges the capacitor 124 for a fixed time and hence the voltage on the capacitor 124 is related to the resistor 122 temperature, which of course is related to the intensity of the radiation impinging the pixel.

In one aspect, the present invention provides a new readout method where the background subtraction issue is handled at the detector level. The method may be most applicable to arrays of bolometer detectors, but can be applied in a generalized form to other uncooled (or cooled) detector arrays. Applying this readout method eliminates the need for external memory and reduces the dynamic range needed by the pixel preamplifier 128.

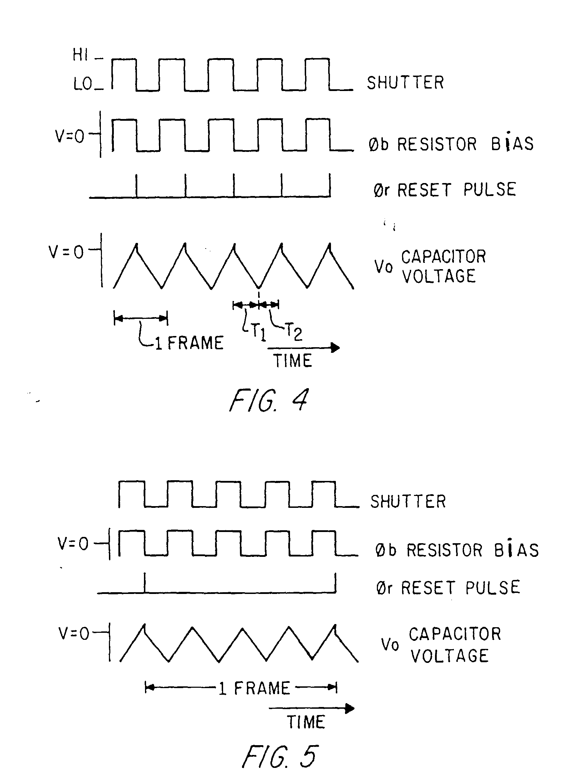

The voltage on the output of the capacitor 124 is shown in Figure 3. In the operation of the sensing array, the desired output signal is obtained from the difference between two consecutive array outputs. The first output is obtained with the IR image deliberately defocused on the array and is used to determine the background flux associated with the scene. The background is determined during time period T₁ while the capacitor discharges to the appropriate value. The second output is obtained with the image sharply focused on the array. The image is determined during time period T₂ while the capacitor charges to the appropriate (i.e., proportional to the impinging radiation) value.

Operation will be better understood by reference to Figure 4 which shows the relationship between the shutter the resistor bias Φ_{b}, , the reset pulse Φᵣ, and the output voltage Vₒ on the capacitor. The shutter is defined as being having a focused image in the high state and an defocused image in the low state. In practice the shutter may be any method which adjusts the focusing of the radiation on the array. Although not illustrated, more than two states of focus may be possible.

The waveforms and voltages are presented for discussion of the principles of operation and do not represent the exclusive method for proper operation. For example the phase relationships between the waveforms and bias levels may be adjusted.

Operation of the proposed readout process is best understood by beginning the description of operation immediately after the detector has completed integration and has been readout (i.e., at the beginning of time period T₁). The voltage on integration capacitor 124 is then clamped to a reference value, V=0 for illustration, and the bias on the resistor 122 is switched to a first fixed value which is less than the reference value V=0 (e.g., negative). The shutter is in the defocused mode, and the voltage on the integration capacitor 124 is decreasing in proportion to time and the temperature of the resistor 122. Since the shutter is defocused the resistor temperature is proportional to the background radiation level. The voltage across the capacitor 124 reaches a minimum value just prior to the shutter transition to the focused mode and the switching of the bias across the resistor 122 to the second fixed value which is greater than the reference voltage V=0 (e.g., positive). This minimum capacitor voltage is a function of the resistor temperature during integration, i.e. dependent on the "dark" scene background level.

With the bias across the resistor positive and the shutter in the focused mode, the voltage across the capacitor 124 increases with time and the resistor temperature which now is proportional to the image radiation intensity level. At the end of the shutter open time, the voltage across the resistor is readout by the preamplifier. This voltage represents the difference between the background and signal levels of the scene.

In this system, the preamplifier 128 must only sense this one difference signal which is much smaller than either the image or background signals. Both the direct and background signals would have to pass through the amplifier 128 if external differencing is used.

In typical applications, the signal is sampled 60 times per second (i.e., 60 Hz). This signal would be compatible with typical video applications. Methods of displaying the array on a display are known in the art.

It should be noted that this operating mode requires the time constant of the temperature dependent resistor and integration capacitor to exceed the frame time of the system to avoid saturation of the integration capacitor. In practice, the size of the integration capacitor and the size of the temperature dependent resistor are limited by fabrication constraints and shot noise considerations. Hence, the integration time constant will in general be less than the frame time. Under these conditions, the operation can be revised to synchronize the shutter and φ_{b} while φᵣ and the readout remain synchronized with the frame rate. In this mode of operation, shown in Figure 5, the shutter speed will be a multiple of the frame rate and will be limited at the high end by the thermal time constant of the pixel.

## Claims

1. A pixel detector (120) for detecting radiation emanating from an object (116) and focused onto the detector, wherein the said focused radiation alternates with reference radiation, the said pixel detector (120) comprising: a resistive detector element (122) with a resistance dependent on the said radiation and having first and second terminals; a capacitor (124); circuitry (126) for applying a reference voltage; and circuitry (128) for sensing an ouput voltage dependent upon a difference between said focused radiation and said reference radiation; characterised in that the said capacitor (124) and the said circuitry (126) for applying a reference voltage are coupled to the first terminal of the resistive detector element (122); in that the pixel detector comprises bias circuitry for applying to the second terminal of said resistive detector element (122) a first voltage (Φb) when said reference radiation is incident on the detector element and a second voltage (Φb) when the focused radiation is incident on the detector element, the reference voltage being between the first and second voltages (Φb); in that the detector is for use with defocused background radiation as the said reference radiation; and in that the output voltage is a voltage on the first terminal of the resistive element.

2. The detector of claim 1, wherein said resistive element is a temperature dependent resistor (122) with a temperature proportional to said radiation.

3. The detector of claim 1 or claim 2, wherein said circuitry for applying a reference voltage comprises a transistor (126).

4. The detector of any one of claims 1 to 3, wherein said circuitry for sensing an output voltage comprises a preamplifier (128).

5. The detector of any one of claims 1 to 4, wherein said reference voltage is zero volts.

6. The detector of any one of claims 1 to 5, wherein said first voltage (Φb) is less than said reference voltage and said second voltage (Φb) is greater than said reference voltage.

7. The detector of any one of claims 1 to 6, wherein said reference voltage is applied 60 times per second.

8. An infrared imaging system (100) for detecting radiation emanating from an object (116), comprising an array of detectors (120) as claimed in any one of claims 1 to 7, means (102) for focusing radiation from the object onto the detectors, and a shutter (104) arranged to cause defocused radiation from the object, supplied as the said reference radiation, to alternate with the focused radiation.

9. A method of detecting the intensity of radiation emanating from an object relative to a reference radiation intensity at a pixel detector (120), comprising the steps of:
providing a resistive element (122) with a resistance dependent upon the intensity of radiation impinging on said detector and having first and second terminals;
providing an integration element (124) coupled to the first terminal of the resistive element (122);
setting said first terminal to a reference voltage;
exposing said detector to said reference radiation and applying a first voltage to the second terminal of said resistive element and integrating corresponding to the reference radiation level;
focusing said radiation on said detector; and
sensing an output voltage level;
characterised by:
exposing the said detector to defocused radiation from the object as the said reference radiation;
setting the second terminal of the resistive element (122) to a second voltage while focusing said radiation on said detector (120) and integrating corresponding to the focused radiation level, the reference voltage being between the first and second voltages; and
sensing a voltage level in the integrating element as the said output voltage level.

10. The method of claim 9, wherein said resistive element (122) is a temperature dependent resistor with a temperature proportional to said radiation.

11. The method of claim 9 or claim 10, wherein said integration element is a capacitor.

12. The method of any one of claims 9 to 11, wherein said reference voltage is zero volts.

13. The method of any one of claims 9 to 12, wherein said first voltage is less than said reference voltage and said second voltage is greater than said reference voltage.

14. The method of any one of claims 9 to 13, wherein said setting, exposing, focusing, and sensing steps are performed repetitively.

15. The method of claim 14, wherein said setting, exposing, focusing, and sensing steps are performed 60 times per second.

## Revendications

1. Détecteur de pixels (120) pour détecter un rayonnement émanant d'un objet (116) et focalisé sur le détecteur, dans lequel ledit rayonnement focalisé alterne avec un rayonnement de référence, ledit détecteur de pixels (120) comprenant : un élément détecteur résistif (122) avec une résistance qui dépend dudit rayonnement et ayant des première et seconde bornes ; un condensateur (124) ; un circuit (126) pour appliquer une tension de référence ; un circuit (128) pour détecter une tension de sortie dépendant d'une différence entre ledit rayonnement focalisé et ledit rayonnement de référence, caractérisé en ce que ledit condensateur (124) et ledit circuit (126) pour appliquer une tension de référence sont couplés à la première borne de l'élément détecteur résistif (122) ; en ce que le détecteur de pixels comprend un circuit de polarisation pour appliquer à la seconde borne dudit élément détecteur résistif (122) une première tension (φb) lorsque ledit rayonnement de référence est incident sur l'élément détecteur et une seconde tension (φb) lorsque le rayonnement focalisé est incident sur l'élément détecteur, la tension de référence étant comprise entre les première et seconde tensions (φb) ; en ce que le détecteur est destiné à être utilisé avec un rayonnement de fond défocalisé en tant que rayonnement de référence; et en ce que la tension de sortie est une tension sur la première borne de l'élément résistif.

2. Détecteur selon la revendication 1, dans lequel ledit élément résistif est une résistance (122) dépendant de la température avec une température proportionnelle audit rayonnement.

3. Détecteur selon la revendication 1 ou 2, dans lequel ledit circuit pour appliquer une tension de référence comprend un transistor (126).

4. Détecteur selon l'une des revendications 1 à 3 , dans lequel ledit circuit pour détecter une tension de sortie comprend un préamplificateur (128).

5. Détecteur selon l'une quelconque des revendications 1 à 4, dans lequel ladite tension de référence est zéro volt.

6. Détecteur selon l'une quelconque des revendications 1 à 5, dans lequel ladite première tension (φb) est inférieure à ladite tension de référence, et ladite seconde tension (φb) est supérieure à ladite tension de référence.

7. Détecteur selon l'une quelconque des revendications 1 à 6, dans lequel ladite tension de référence est appliquée 60 fois par seconde.

8. Système de formation d'image infrarouge (100) pour détecter un rayonnement émanant d'un objet (116), comprenant un réseau de détecteurs (120) suivant l'une quelconque des revendications 1 à 7, des moyens (102) pour focaliser le rayonnement venant de l'objet sur les détecteurs, et un obturateur (104) agencé pour faire alterner le rayonnement défocalisé provenant de l'objet délivré en tant que ledit rayonnement de référence avec le rayonnement focalisé.

9. Procédé de détection de l'intensité d'un rayonnement émanant d'un objet par rapport à une intensité de rayonnement de référence sur un détecteur de pixels (120), comprenant les phases consistant à :
prévoir un élément résistif (122) avec une résistance dépendant de l'intensité du rayonnement frappant ledit détecteur et ayant des première et seconde bornes ;
prévoir un élément d'intégration (124) couplé à la première borne de l'élément résistif (122) ;
établir ladite première borne à une tension de référence ;
exposer ledit détecteur audit rayonnement de référence et appliquer une première tension à la seconde borne dudit élément résistif et intégrer de manière correspondante au niveau du rayonnement de référence;
focaliser ledit rayonnement sur ledit détecteur ; et
détecter un niveau de tension de sortie ;
caractérisé en ce qu'il consiste à :
exposer ledit détecteur à un rayonnement défocalisé provenant de l'objet en tant que ledit rayonnement de référence ;
établir la seconde borne de l'élément résistif (122) à une seconde tension tout en focalisant ledit rayonnement sur ledit détecteur (120) et intégrer de façon correspondante au niveau de rayonnement focalisé, la tension de référence étant comprise entre les première et seconde tensions; et
détecter un niveau de tension dans l'élément d'intégration en tant que ledit niveau de tension de sortie.

10. Procédé suivant la revendication 9, dans lequel ledit élément résistif (122) est une résistance dépendante de la température avec une température proportionnelle audit rayonnement.

11. Procédé suivant la revendication 9 ou 10, dans lequel ledit élément d'intégration est un condensateur.

12. Procédé suivant l'une quelconque des revendications 9 à 11, dans lequel ladite tension de référence est zéro volt.

13. Procédé suivant l'une quelconque des revendications 9 à 12, dans lequel ladite première tension est inférieure à ladite tension de référence et ladite seconde tension est supérieure à ladite tension de référence.

14. Procédé suivant l'une quelconque des revendications 9 à 13, dans lequel lesdites phases d'établissement, d'exposition, de focalisation et de détection sont réalisées de façon répétitive.

15. Procédé suivant la revendication 14, dans lequel lesdites phases d'établissement, d'exposition, de focalisation et de détection sont réalisées 60 fois par seconde.

## Patentansprüche

1. Pixeldetektor (120) zum Erfassen einer von einem Objekt (116) ausgehenden und auf den Detektor fokussierten Strahlung, wobei die fokussierte Strahlung mit einer Referenzstrahlung abwechselt, mit: einem widerstandsbehafteten Detektorelement (122) mit einem Widerstand, der von der Strahlung abhängt, und mit einem ersten und einem zweiten Anschluß; einem Kondensator (124); einer Schaltung (126) zum Anlegen einer Referenzspannung; einer Schaltung (128) zum Feststellen einer Ausgangsspannung, die von einer Differenz zwischen der fokussierten Strahlung und der Referenzstrahlung abhängt; dadurch gekennzeichnet, daß der Kondensator (124) und die Schaltung (126) zum Anlegen einer Referenzspannung mit dem ersten Anschluß des widerstandsbehafteten Detektorelements (122) verbunden sind; daß der Pixeldetektor eine Vorspannungsschaltung enthält, die an den zweiten Anschluß des widerstandsbehafteten Detektorelements (122) eine erste Spannung (Φb) anlegt, wenn die Referenzstrahlung auf das Detektorelement fällt, und eine zweite Spannung (Φb) anlegt, wenn die fokussierte Strahlung auf das Detektorelement fällt, wobei die Referenzspannung zwischen der ersten und der zweiten Spannung (Φb) liegt; daß der Detektor mit der defokussierten Hintergrundstrahlung als Differenzstrahlung zu verwenden ist; und daß die Ausgangsspannung eine Spannung am ersten Anschluß des widerstandsbehafteten Elements ist.

2. Detektor nach Anspruch 1, bei welchem das widerstandsbehaftete Element ein temperaturabhängiger Widerstand (122) mit einer zu der Strahlung proportionalen Temperatur ist.

3. Detektor nach Anspruch 1 oder Anspruch 2, bei welchem die Schaltung zum Anlegen einer Referenzspannung einen Transistor (126) umfaßt.

4. Detektor nach einem der Ansprüche 1 bis 3, bei welchem die Schaltung zum Feststellen einer Ausgangsspannung einen Vorverstärker (128) umfaßt.

5. Detektor nach einem der Ansprüche 1 bis 4, bei welchem die Referenzspannung 0 V beträgt.

6. Detektor nach einem der Ansprüche 1 bis 5, bie welchem die erste Spannung (Φb) kleiner als die Referenzspannung ist und die zweite Spannung (Φb) größer als die Referenzspannung ist.

7. Detektor nach einem der Ansprüche 1 bis 6, bei welchem die Referenzspannung 60 mal pro Sekunde angelegt wird.

8. Infrarot-Abbildungssystem (100) zum Erfassen einer von einem Objekt (116) ausgehenden Strahlung mit einer Matrix aus Detektoren (120) nach einem der Ansprüche 1 bis 7, Mitteln (102) zum Fokussieren der von dem Objekt ausgehenden Strahlung auf die Detektoren und einem Verschluß (104), der so angeordnet ist, daß er das Abwechseln der von dem Objekt kommenden defokussierten Strahlung, die als die Referenzstrahlung angelegt wird, mit der fokussierten Strahlung bewirkt.

9. Verfahren zum Erfassen der Intensität einer von einem Objekt ausgehenden Strahlung relativ zu einer Referenzstrahlungsintensität an einem Pixeldetektor (120), mit den Schritten:
Vorsehen eines widerstandsbehafteten Elements (122) mit einem von der Intensität der auf den Detektor auftreffenden Strahlung abhängigen Widerstand und mit einem ersten sowie einem zweiten Anschluß;
Vorsehen eines Integrationselements (124), das mit dem ersten Anschluß des Widerstands behafteten Elements (122) verbunden ist;
Legen des ersten Anrisses auf eine Referenzspannung;
Aussetzen des Detektors einer Referenzstrahlung und Anlegen einer ersten Spannung an den zweiten Anschluß des widerstandsbehafteten Elements und Durchführen einer Integration entsprechend dem Referenzstrahlungswert;
Fokussieren der Strahlung auf den Detektor; und
Feststellen eines Ausgangsspannungswerts;
gekennzeichnet durch:
Aussetzen des Detektors der fokussierten Strahlung von dem Objekt als die Referenzstrahlung;
Legen des zweiten Anschlusses des widerstandsbehafteten Elements (122) auf eine zweite Spannung während der Fokussierung der Strahlung auf den Detektor (120) und Integrieren entsprechend dem fokussierten Strahlungswert, wobei die Referenzspannung zwischen der ersten und der zweiten Spannung liegt; und
Feststellen eines Spannungswerts in dem Integrationselement als Ausgangsspannungswert.

10. Zu Verfahren nach Anspruch 9, bei welchem das widerstandsbehaftete Element (122) ein temperaturabhängiger Widerstand mit einer der Strahlung proportionalen Temperatur ist.

11. Verfahren nach Anspruch 9 oder Anspruch 10, bei welchem das Integrationselement ein Kondensator ist.

12. Verfahren nach einem der Ansprüche 9 bis 11, bei welchem die Referenzspannung 0 V beträgt.

13. Verfahren nach einem der Ansprüche 9 bis 12, bei welchem die erste Spannung niedriger als die Referenzspannung ist und die zweite Spannung größer als die Referenzspannung ist.

14. Verfahren nach einem der Ansprüche 9 bis 13, bei welchem die Schritte des Legens, Aussetzens, Fokussierens und Feststellens wiederholt durchgeführt werden.

15. Verfahren nach Anspruch 14, bei welchem die Schritte des Legens, Aussetzens, Fokussierens und Feststellens 60 mal pro Sekunde durchgeführt werden.
